Europäisches Patentamt

European Patent Office

Office européen des brevets

(11) Veröffentlichungsnummer: **0 248 469 B1**

(12) **EUROPÄISCHE PATENTSCHRIFT**

(45) Veröffentlichungstag der Patentschrift: **01.04.92**

(21) Anmeldenummer: **87200947.7**

(22) Anmeldetag: **20.05.87**

(51) Int. Cl.⁵: **G01N 24/08**

(54) **Kernspintomographieverfahren.**

(30) Priorität: **31.05.86 DE 3618432**

(43) Veröffentlichungstag der Anmeldung:
**09.12.87 Patentblatt 87/50**

(45) Bekanntmachung des Hinweises auf die
Patenterteilung:
**01.04.92 Patentblatt 92/14**

(84) Benannte Vertragsstaaten:
**DE FR GB NL SE**

(56) Entgegenhaltungen:
**EP-A- 0 098 426**
**WO-A-81/02788**
**DE-A- 2 921 253**
**DE-A- 3 519 305**

**PHYSICS IN MEDICINE AND BIOLOGY, Band
30, Nr. 4, April 1985, Seiten 341-344, Bristol,
GB; A. HAASE et al.: "1H NMR chemical shift
selective imaging"**

(73) Patentinhaber: **Philips Patentverwaltung
GmbH
Wendenstrasse 35 Postfach 10 51 49
W-2000 Hamburg 1(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB NL SE**

(72) Erfinder: **McKinnon, Graeme Colin
Höschgasse 62
CH-8008 Zürich(CH)**

(74) Vertreter: **Hartmann, Heinrich, Dipl.-Ing. et al
Philips Patentverwaltung GmbH Wendenstrasse 35 Postfach 10 51 49
W-2000 Hamburg 1(DE)**

## Beschreibung

Die Erfindung betrifft ein Verfahren gemäß dem Oberbegriff des Anspruchs 1 sowie eine Anordnung zur Durchführung eines solchen Verfahrens. Ein derartiges Verfahren ist aus der Zeitschrift "electromedica 54 (1986) Heft 1, Seiten 15-18 bekannt. Die Sequenzen können dabei in so geringem zeitlichem Abstand aufeinanderfolgen, daß bei Beginn einer Sequenz die durch die vorangegangene Sequenz angelegte Kernmagnetisierung den Gleichgewichtszustand noch nicht erreicht hat. Dabei beeinflußt die in einer Sequenz angeregte Kernmagnetisierung die mit der nächsten Sequenz erzeugten Kernresonanzsignale, weil der Abstand der Sequenzen sehr gering ist. Deshalb ergeben sich bei dem bekannten Verfahren Artefakte.

Aufgabe der vorliegenden Erfindung ist es, ein Verfahren der eingangs genannten Art so auszugestalten, daß auch bei kurzer Periodendauer einer Sequenz weitgehend artefaktfreie Bilder erhalten werden können. Diese Aufgabe wird erfindungsgemäß durch die im kennzeichnenden Teil des Anspruchs 1 angegebenen Maßnahmen gelöst.

Die Erfindung basiert auf der Erkenntnis, daß als Kernspin-Resonanzsignale nicht nur durch den freien Induktionszerfall hervorgerufene Signale (sogenannte FID-Signale) auftreten können, sondern durch das Zusammenwirken der Hochfrequenzimpulse zweier aufeinanderfolgender Sequenzen auch sogenannte Spin-Echo-Signale und durch das Zusammenwirken der Hochfrequenzimpulse von drei aufeinanderfolgenden Sequenzen auch noch stimulierte Echosignale. Die Spin-Echo-Signale und die stimulierten Echosgnale besitzen Anteile, die eine von der Phasenlage der FID-Signale abweichende Phasenlage haben. Diese Anteile werden jedoch durch den erfindungsgemäßen zeitlichen Verlauf der magnetischen Gradientenfelder unterdrückt. Außerdem besitzen diese Signale Anteile, die die gleiche Phasenlage haben wie das FID-Signal. Diese Anteile werden nicht unterdrückt, weil sich die Wirkung der magnetischen Gradientenfelder auf diese Anteile kompensiert, wenn erfindungsgemäß das zeitliche Integral über die während einer Sequenz wirksamen Gradientenfelder für alle Sequenzen (zur Untersuchung einer Schicht) gleich und verschieden von Null ist.

Die Erfindung ist sowohl bei einem mehrdimensionalen Fourier-Bildgebungsverfahren als auch bei einem Projektions-Rekonstruktionsverfahren anwendbar.

Bei dem Fourier-Bildgebungsverfahren, wobei jede Sequenz aufeinanderfolgend eine Selektionsphase, in der ein Hochfrequenzimpuls und ein erstes magnetisches Gradientenfeld auf den Untersuchungsbereich einwirken, eine Präparationsphase, in der ein zweites magnetisches Gradientenfeld mit von Sequenz zu Sequenz veränderbarer Größe des Gradienten auf den Untersuchungsbereich einwirkt, und eine Lesephase umfaßt, in der en drittes magnetisches Gradientenfeld auf den Untersuchungsbereich einwirkt und das dabei erzeugte Kernspin-Resonanzsignal erfaßt wird, ist in Ausgestaltung der Erfindung vorgesehen, daß auf die Lesephase eine weitere Phase folgt, während der das zweite magnetische Gradientenfeld derart geschaltet wird, daß das zeitliche Integral über das zweite magnetische Gradientenfeld während einer Sequenz für alle Sequenzen den gleichen Wert - vorzugsweise Null - hat.

Bei einem Projektions-Rekonstruktionsverfahren, wobei jede Sequenz eine Selektionsphase, in der ein Hochfrequenzimpuls und ein erstes magnetisches Gradientenfeld auf den Untersuchungsbereich einwirken, und eine Lesephase umfaßt, in der ein weiteres magnetisches Gradientenfeld mit für alle Sequenzen gleicher Amplitude, jedoch von Sequenz zu Sequenz veränderbarer Richtung geschaltet wird und in der ein im Untersuchungsbereich erzeugtes Kernspin-Resonanzsignal erfaßt wird, ist in Ausgestaltung der Erfindung vorgesehen, daß im Anschluß an die Lesephase ein magnetsiches Gradientenfeld ein- und ausgeschaltet wird, dessen Richtung der Richtung des in der Lesephase wirksamen magnetischen Gradientenfeldes entgegengesetzt ist und dessen Größe so gewählt ist, daß das zeitliche Integral über das zweite magnetische Gradientenfeld für alle Sequenzen Null ist.

In beiden Fällen ist es in weiterer Ausgestaltung der Erfindung von Vorteil, daß in der auf die Lesephase folgenden Phase das erste magnetische Gradientenfeld mit einer für alle Sequenzen gleichen Phasenlage ein- und ausgeschaltet wird. Diese Ausgestaltung ist insbesondere für Projektions-Rekonstruktionsverfahren wichtig; bei einem Fourier-Bildgebungsverfahren könnte statt des ersten magnetischen Gradientenfeldes in der weiteren Phase auch das in der Lesephase wirksame magnetische Gradientenfeld in geeigneter Weise geschaltet werden.

Eine Anordnung zur Durchführungs des Verfahrens nach Anspruch I mit Mitteln zum Erzeugen eines homogenen stationären Magnetfeldes, Mitteln zum Erzeugen von Hochfrequenzimpulsen, Mitteln zum Erzeugen wenigstens eines magnetischen Gradientenfeldes mit von Sequenz zu Sequenz veränderbarer Größe oder Richtung des Gradienten, Mitteln zum Erfassen von Kernspin-Resonanzsignalen, ist dadurch gekennzeichnet, daß die Mittel zum Erzeugen des Gradientenfeldes bzw. der Gradientenfelder durch Steuermittel so gesteuert sind, daß das zeitliche Integral über alle während einer Sequenz wirksamen magnetischen Gradientenfelder für alle Sequenzen gleich und verschieden von Null ist.

Die Erfindung wird nachstehend anhand der Zeichnung näher erläutert. Es zeigen:

Fig. I ein Kernspin-Tomographiegerät, bei dem die Erfindung anwendbar ist,

Fig. 2 ein Blockschaltbild eines solchen Gerätes,

Fig. 3 den zeitlichen Verlauf verschiedener Signale bei einer Fourier-Sequenz,

Fig. 4 den zeitlichen Verlauf dieser Signale bei einer Projektions-Rekonstruktionssequenz, und

Fig. 5 ein Zeitdiagramm verschiedener Signale zur Erläuterung der Wirkung der Erfindung.

Das in Fig. I schematisch dargestellte Kernspin-Tomographiegerät enthält eine aus vier Spulen I bestehende Anordnung zur Erzeugung eines homogenen stationären Magnetfeldes, das z.B.2 T beträgt. Dieses Feld verläuft in z-Richtung eines kartesischen xyz-Koordinatensystems. Die zur z-Achse konzentrisch angeordneten Spulen I können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5, die den gleichen Aufbau wie die Spulen 7 habe können, die jedoch diesen gegenüber um 90° versetzt angeordnet sind. Von diesen vier Spulen sind in Fig. I nur zwei dargestellt. Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des kartesischen Koordinatensystems bildet, nur durch das stationäre homogene Magnetfeld der Spulenanordnung I bestimmt.

Weiterhin ist eine Hochfrequenzspule II symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes, verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. Im Anschluß an jeden Hochfrequenzimpuls dient die Hochfrequenzspule II zum Empfangen von im Untersuchungsbereich erzeugten Kernspin-Resonanzsignalen. An ihrer Stelle kann aber auch eine gesonderte Hochfrequenz-Empfangsspule verwendet werden.

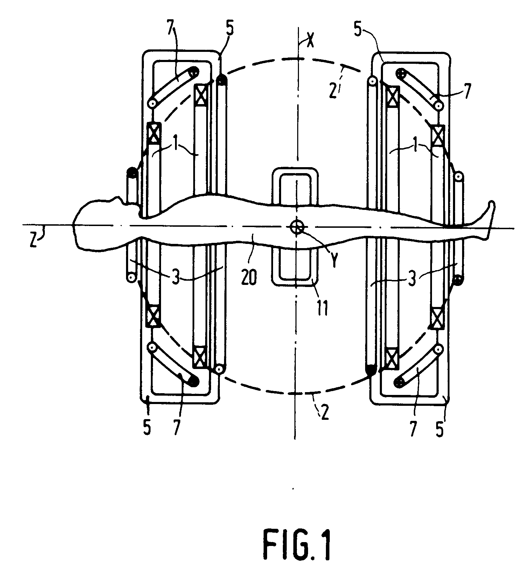

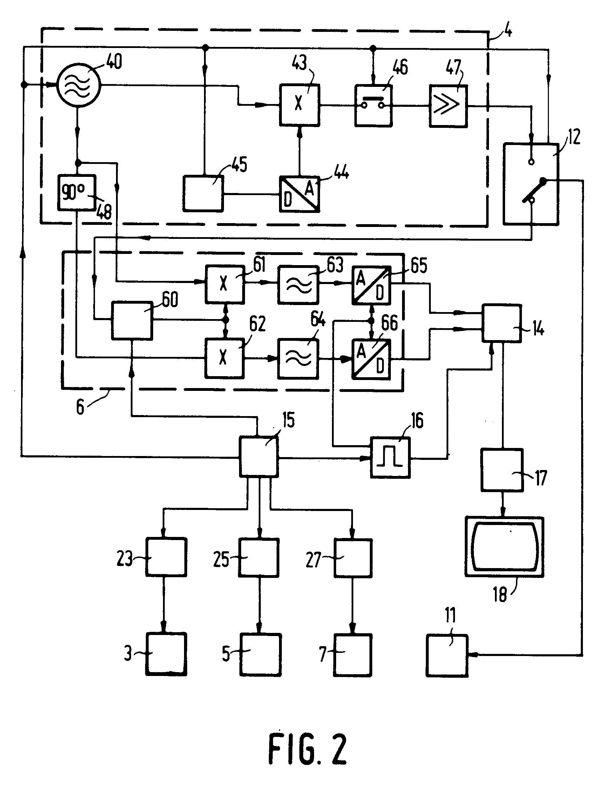

Fig. 2 zegt ein vereinfachtes Blockschaltbild dieses Kernspin-Tomographiegerätes. Die Hochfrequenzspule II st über eine Umschalteinrichtung I2 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmorfrequenz der anzuregenden Atomkerne bei der von den Spulen I erzeugten Feldstärke aufweist. Die Larmorfrequenz f berechnet sich bekanntlich nach der Beziehung f = cB, wobei B die magnetische Induktion in dem stationären homogenen Magnetfeld darstellt und c das gyromagnetische Verhältnis, das beipielsweise für Protonen 42,56 MHz/T beträgt. Der Ausgang des Oszillators 40 ist mit einem Eingang einer Mischstufe 43 verbunden. Der Mischstufe 43 wird en zweites Eingangssignal von einem Digital-Analog-Wandler 44 zugeführt, dessen Ausgang mit einem digitalen Speicher 45 verbunden ist. Aus dem Speicher wird - gesteuert durch eine Steuereinrichtung I5 - eine Folge von ein Hüllkurvensignal darstellenden digitalen Datenworten ausgelesen.

Die Mischstufe 43 verarbeitet die ihr zugeführten Engangssignale so, daß an ihrem Ausgang die mit dem Hüllkurvensignal modulierte Trägerschwingung erscheint. Das Ausgangssignal der Mischstufe 43 wird über einen von der Steuereinrichtung I5 gesteuerten Schalter 46 einem Hochfrequenz-Leistungsverstärler 47 zugeführt, dessen Ausgang mit der Umschalteinrichtung I2 verbunden ist Diese wird ebenfalls durch die Steuereinrichtung I5 gesteuert.

Der Empfänger 6 enthält einen Hochfrequenzverstärker 60, der mit der Umschalteinrichtung verbunden ist und dem das in der Hochfrequenzspule II induzierte stimulierte Echosignal zugeführt wird, wobei die Umschalteinrichtung den entsprechenden Schaltzustand haben muß. Der Verstärker 60 besitzt einen von der Steuereinrichtung I5 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 6I und 62 verbunden, die jeweils ein dem Produkt ihrer Eingangssignale entsprechendes Ausgangssignal liefern. Den zweiten Eingängen der Mischstufen 6I und 62 wird ein Signal mit der Frequenz des Oszillators 40 zugeführt, wobe zwischen den Signalen an den beiden Eingängen eine Phasenverschiebung von 90° besteht. Diese Phasenverschiebung wird mit Hilfe eines 90° Phasendrehgliedes 48 erzeugt, dessen Ausgang mit dem Eingang der Mischstufe 62 und dessen Eingang mit dem Eingang der Mischstufe 6l und mit dem Ausgang des Oszillators 40 verbunden ist.

Die Ausgangssignale der Mischstufe 6l und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 6l...64 in digitale Datenworte um, die einem Speicher l4 zugeführt werden. Die Analog-Digital-Wandler 65 und 66 sowie der Speicher erhalten ihre Taktimpulse von einem Taktimpulsgenerator l6, der über eine Steuerleitung von der Steuereinrichtung l5 blockiert bzw. freigegeben werden kann, so daß nur in einem durch die Steuerenrichtung l5 definierten Meßintervall die von der Hochfrequenzspule ll gelieferten, in den Niederfrequenzbereich transponierten Signale in eine Folge digitaler Datenworte umgesetzt und in dem Speicher l4 gespeichert werden können.

Die im Speicher l4 gespeicherten Datenworte bzw. Abtastwerte werden einem Rechner zugeführt, der daraus die räumliche Verteilung der Kernmagnetisierung in einer Schicht des Untersuchungsbereiches ermittel und die ermittelte Verteilung an einer geeigneten Wiedergabeeinheit, z.B. einem Monitor l8, ausgibt. - Die drei Spulenanordnungen 3, 5 und 7 werden von Stromgeneratoren 23, 25 und 27 jeweils mit einem Strom versorgt, dessen zeitlicher Verlauf durch die Steuereinheit l5 steuerbar ist.

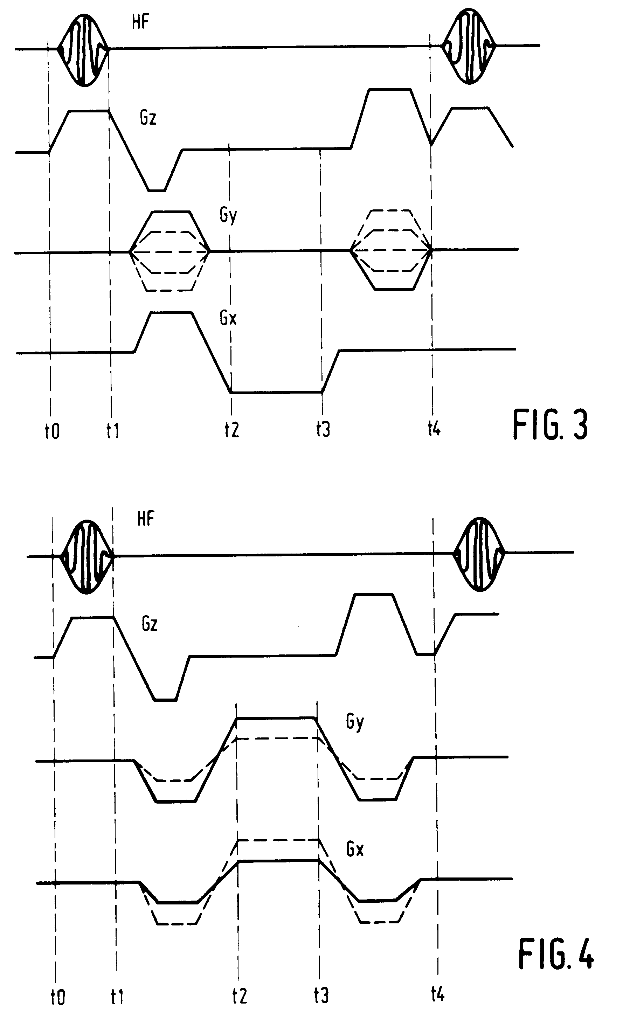

In Fig. 3 ist der zeitliche Verlauf der von der Hochfrequenzspule ll und den Gradientenspule 3, 5 und 7 erzeugten Signale bei einem zweidimensionalen FourierVerfahren dargestellt, und zwar im wesentlichen nur für eine Sequenz, die zur Zeit t = t0 beginnt und zur Zeit t = t4 endet. Im Zeitraum t0 bis tl wird das von den Spulen 3 erzeugte magnetische Gradientenfeld Gz eingeschaltet (Fig. 3, zweite Zeile) und es wird ein Hochfrequenzimpuls HF erzeugt (Fig. 3, erste Zeile), wenn das magnetische Gradientenfeld Gz einen stationären Wert erreicht hat. Anschließend wird die Polarität des magnetischen Gradientenfeldes Gz umgekehrt und danach wird dieses Feld zunächst abgeschaltet, wobei der zeitliche Verlauf so gewählt ist, daß das zeitliche Integral über das magnetische Gradientenfeld Gz von der Mitte des Hochfrequenzimpulses HF bis zum Abschalten gerade Null ist. Dadurch wird erreicht, daß die Kernmagnetisierung in der durch den Hochfrequenzimpuls in Verbindung mit dem magnetischen Gradientenfeld Gz angeregten, zur z-Achse senkrechten Schicht eine von der z-Richtung unabhängige Phasenlage hat.

Nach dem Hochfrequenzimpuls wird in dem Zeitraum von t = tl und t = t2 außerdem noch das magnetische Gradientenfeld Gy, das von den Spulen 5 und dem Generator 25 erzeugt wird, ein- und ausgeschaltet (Fig. 3, Zeile 3), wobei - wie durch gestrichelte Linien angedeutet - der Gradient dieses Feldes von Sequenz zu Sequenz variiert wird. Weiterhin wird in dem Intervall tl-t2 ein magnetisches Gradientenfeld Gx zunächst mit einer ersten Polarität eingeschaltet, die anschließend umgeschaltet wird, bis zur Zeit t = t2 das magnetische Gradientenfeld Gx einen stationären Wert erreicht hat (Fig. 3, 4. Zeile).

Das magnetische Gradientenfeld Gx bleibt danach bis zum Zeitpunkt t = t3 konstant. In diesem Zeitraum tritt ein Kernspin-Resonanzsignal auf, das sein Maximum zu dem Zeitpunkt erreicht, in dem das zeitliche Integral über das magnetische Gradientenfeld Gx Null ist. Dieses Signal wird im Zeitraum t2 bis t3 erfaßt, d.h. die Steuereinrichtung l5 erzeugt ein Freigabesignal für den Taktimpulsgenerator l6, so daß die von der Hochfrequenzspule ll gelieferten, in den Niederfrequenzbereich transponierten Signale in eine Folge digitaler Datenworte umgesetzt und in dem Speicher l4 gespeichert werden können. Anschließend wird auch das Feld Gx abgeschaltet.

Insoweit als bisher beschrieben ist das Verfahren gemäß Fig. 3 bekannt - z.B. aus der eingangs erwähnten Zeitschrift Phys.Med.Biol., Vol. 25, Seiten 75l bis 756. Erfindungsgemäß wird nun nach der Erfassung des Kernspin-Resonanzsignales das magnetische Gradientenfeld Gy wieder eingeschaltet, und zwar mit der entgegengesetzten Polarität wie im Zeitintervall tl-t2. Dauer und Stärke des magnetischen Gradientenfeldes sind dabei so gewählt, daß das zeitliche Integral über den Gradienten des Feldes Gy für eine Sequenz gerade Null ist. Gleichzeitig wird das magnetische Gradientenfeld Gz ein- und ausgeschaltet, so daß die in der Schicht angeregte Kernmagnetisierung dephasiert wird.

Zum Zeitpunkt t = t4, d.h. etwa 30 ms nach dem Zeitpunkt t = t0 folgt die nächste Sequenz, wobei der zeitliche Verlauf der Hochfrequenzimpulse HF (erste Zeile)des magnetischen Gradientenfeldes Gz (zweite Zeile) und des magnetischen Gradientenfeldes Gx (vierte Zeile) unverändert bleiben. Lediglich das magnetische Gradientenfeld Gy (dritte Zeile) wird im Zeitraum tl-t2 verändert, doch wird diese Änderung durch eine entgegengesetzt gleiche Änderung des Feldes Gy im Zeitraum t3-t4 kompensiert.

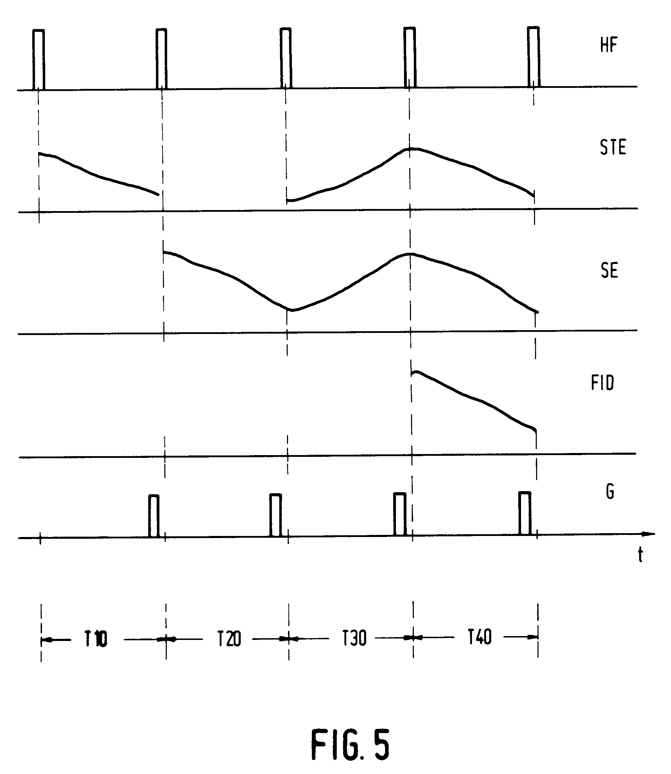

Durch den beschriebenen zeitlichen Verlauf wird erreicht, daß in jeder Sequenz die angeregte Kernmagnetisierung im Anschluß an die Lesephase (t2-t3) jeweils im gleichen Maße dephasiert ist, weil das zeitliche Integral über die magnetischen Gradientenfelder während einer Sequenz für alle Sequenzen gleich ist. Die Wirkung dieser Maßnahme wird anhand von Fig. 5 näher erläutert. Die erste Zeile von Fig. 5 zeigt schematisch den zeitlichen Verlauf der Hochfrequenzimpulse HF mehrerer aufeinanderfolgender Sequenzen. Der Abstand zwischen zwei Hochfrequenzimpulsen, d.h. die Periodendauer einer Sequenz beträgt dabei etwa 30 ms.

Es ist bekannt, daß durch drei aufeinanderfolgende Hochfrequenzimpulse stimulierte Echosignale erzeugt werden können. Das maximale Signal ergibt sich dabei, wenn alle drei Impulse einen Flipwinkel von 90° aufweisen, d.h. wenn die Kernmagnetisierung durch jeden Impuls um jeweils 90° gekippt wird. Doch ergeben sich auch stimulierte Echosignale, wenn die Hochfrequenzimpulse einen kleineren Flipwinkel aufweisen. Das stimulierte Echosignal hat sein Maximum in einem zeitlichen Abstand von dem dritten der drei Hochfrequenzimpulse, der dem zeitlichen Abstand der beiden ersten Hochfrequenzimpulse voneinander entspricht. Somit wird also, wie in Zeile 2 angedeutet, von den drei ersten Hochfrequenzimpulsen ein stimuliertes Echosignal STE erzeugt, dessen Maximum mit dem Auftreten des vierten Hochfrequenzimpulses zusammenfällt. Unter dem Einfluß der Inhomogenitäten des von den Spulen I erzeugten stationären Magnetfeldes dephasiert die Kernmagnetisierung im Anschluß an den vierten Hochfrequenzimpuls, so daß die Signalamplitude mit der Zeit abnimmt; im Gegensatz dazu rephasiert das Echosignal vor dem vierten Hochfrequenzimpuls, wobei seine Amplitude zunimmt.

Durch zwei aufeinanderfolgende Hochfrequenzimpulse können bekanntlich auch Spin-Echo-Signale erzeugt werden - auch wenn der zweite Impuls kein 180°-Impuls ist. In der dritten Zeile ist der zeitliche Verlauf dieser Signale dargestellt, der sich aus dem Zusammenwirken des zweiten und des dritten Hochfrequenzimpulses ergibt. Der zweite Hochfrequenzimpuls erzeugt ein FID-Signal, das unter dem Einfluß der Inhomogenitäten des stationären Magnetfeldes im Zeitintervall T20 nach dem zweiten Hochfrequenzimpuls dephasiert. Nach dem dritten Hochfrequenzimpuls tritt ein Spin-Echo-Signal auf, das sein Maximum ebenfalls während des vierten Hochfrequenzimpulses erreicht und davor einen rephasierenden und danach einen dephasierenden Anteil aufweist.

Die stärksten Kernspin-Resonanzsignale werden durch die FID-Signale, die unmittelbar am Anschluß an die einzelnen Hochfrequenzimpulse auftreten; in Fig. 4 ist das zum vierten Hochfrequenzimpuls gehörende FID-Signal dargestellt. Es dephasiert im Zeitintervall T40 nach diesem Hochfrequenzimpuls unter dem Einfluß der Inhomogenitäten des stationären Magnetfeldes.

Obwohl in den Zeilen zwei, drei und vier nur das durch das Zusammenwirken der ersten drei Impulse erzeugte stimulierte Echosignal STE, das durch das Zusammenwirken des zweiten und dritten Hochfrequenzimpulses erzeugte Spin-Echo-Signal und das durch den vierten Hochfrequenzimpuls erzeugte FID-Signal dargestellt sind, dürfte es einleuchten, daß durch die in der ersten Zeile dargestellten Hochfrequenzimpulse noch eine Vielzahl weiterer Kernspin-Resonanzsgnale erzeugt werden. Beispielsweise erzeugt jeder der dargestellten Hochfrequenzimpulse ein FID-Signal und auch der zweite bis vierte Hochfrequenzimpuls bewirken die Erzeugung eines stimulierten Echosignals, während beispielsweise die beiden ersten Impulse ebenfalls ein Spin-Echo-Signal erzeugen. Diese zusätzlichen Signale sind jedoch der Übersichtlichkeit halber nicht dargestellt.

In der fünften Zeile ist der zeitliche Verlauf des der Dephasierung dienenden und im Zeitraum t3-t4 nach der Lesephase auftretenden magnetischen Gradientenfeldes G -im wesentlichen das Feld Gz - dargestellt. Man erkennt daraus, daß die durch die drei ersten Impulse erzeugte Kernmagnetisierung bzw. das daraus resultierende stimulierte Echosignal mehrmals dem Einfluß des dephasierenden magnetischen Gradientenfeldes ausgesetzt ist. So ist der in der Lesephase im Zeitintervall T30 nach dem dritten Hochfrequenzimpuls auftretende rephasierende Anteil des stimulierten Echosignals STE dem Einfluß der dephasierenden magnetischen Gradientenfelder in den Zeitintervallen TI0 bzw. T20 nach dem ersten bzw. dem zweiten Hochfrequenzimpuls ausgesetzt. Da ein zwischen dem zweiten und dem dritten Hochfrequenzimpuls auftretendes magnetisches Gradientenfeld auf ein stimuliertes Echosignal bekanntlich jedoch keinerlei auf dieses Signal hat, ist lediglich das magnetische Gradientenfeld im Zeitintervall TI0 wirksam. Dadurch wird der rephasierende Anteil des stimulierten Echosignals unterdrückt. - Auf den in der Lesephase im Zeitintervall T40 nach dem vierten Hochfrequenzimpuls auftretenden dephasierenden Anteil des stimulierten Echosignals STE wirken hingegen die während der Zeitintervalle TI0, T20 und T30 erzeugten dephasierenden magnetischen Gradientenfelder ein. Da jedoch bekanntlich der Einfluß eines zwischen dem ersten und dem zweiten Hochfrequenzimpuls auftretenden magnetischen Gradientenfeldes auf das stimulierte Echosignal durch ein magnetisches Gradientenfeld kompensiert werden kann, das im Zeitintervall nach dem dritten Hochfrequenzimpuls aber vor dem Abtasten des stimulierten Echosignals auftritt, bleibt der dephasierende Anteil des stimulierten Echosignals STE (im Intervall T40) von den dephasierenden magnetischen Gradientenfeldern in den Intervallen TI0 und T30 unbeeinflußt.

Der in der Lesephase im Zeitintervall T30 auftretenden rephasierende Anteil des Spin-Echo-Signals SE wird durch das magnetische Gradientenfeld im Intervall T20 beeinflußt und dadurch dephasiert. Auf den in der Lesephase des Intervalls T40 auftretenden dephasierenden Anteil des Spin-Echo-Signals haben hingegen die magnetischen Gradientenfelder, die in den Zeitintervallen T20 und T30 auftreten, eingewirkt. Da sie das gleiche zeitliche Integral aufweisen und da das eine magnetische Gradientenfeld vor und das andere magnetische Gradientenfeld nach dem letzten der beiden das betreffende Spin-Echo-Signal hervorrufenden Impulse auftritt, hebt sich ihre Wirkung in bezug auf den dephasierenden Anteil auf. Dieser bleibt also, ebenso wie der dephasierende Anteil des stimulierten Echosignals, von den zur Dephasierung vorgesehenen magnetischen Gradientenfeldern praktisch unbeeinflußt. Er überlagert sich somit dem durch den vierten Hochfrequenzimpuls erzeugten FID-Signal, so daß, weil alle drei Signale die gleiche Phasenlage haben, ein größeres Signal bzw. ein besseres Signal-Rausch-Verhältnis entsteht.

Die Erfindung nutzt also die Tatsache aus, daß bei derart geringen zeitlichen Abständen der Sequenzen die von den voraufgegangenen Hochfrequenzimpulsen erzeugte Kernmagnetisierung teilweise noch wirksam ist und bewirkt, daß die daraus resultierende Information zu der Information addiert wird, die sich aus dem Hochfrequenzimpuls der jeweiligen Sequenz ergibt.

In Fig. 4 ist eine erfindungsgemäße Sequenz für ein Projektions-Rekonstruktionsverfahren dargestellt. Der zeitliche Verlauf der Hochfrequenzimpulse und des magnetischen Gradientenfeldes Gz entspricht dabei praktisch dem zeitlichen Verlauf dieser Signale bei dem Verfahren nach Fig. 3. Nach dem Hochfrequenzimpuls (im Intervall t0-tl) wird dabei das magnetische Gradientenfeld Gy zunächst mit einer ersten Polarität eingeschaltet, die danach umgeschaltet wird, so daß zum Zeitpunkt t = t2 dieses Feld einen stationären Wert erreicht hat. Das magnetische Gradientenfeld Gx verläuft zeitlich entsprechend - in der Regel jedoch mit einer anderen Amplitude. Die magnetischen Gradientenfelder Gx und Gy bleiben in dem Intervall t2-t3 konstant, und in diesem Intervall werden die Kernspin-Resonanzsignale erfaßt (d.h. der Taktimpulsgenerator l6 in Fig. 2 wird freigegeben). Insoweit als bisher beschrieben ist auch dieses Verfahren bekannt. Nach der Lesephase wird jedoch die Polarität der magnetischen Gradientenfelder Gx und Gy erneut umgeschaltet und danach werden diese Felder abgeschaltet, wobei der zeitliche Verlauf dieser Felder so bemessen st, daß das zeitliche Integral über jedes dieser Felder während einer Sequenz Null ist. Gleichzeitig wird im Zeitraum t3-t4 das der Dephasierung dienende magnetische Gradientenfeld Gz wieder ein- und ausgeschaltet.

In der darauffolgenden Sequenz haben der Hochfrequenzimpuls und das magnetische Gradientenfeld Gz den gleichen zeitlichen Verlauf wie zuvor. Wie gestrichelt angedeutet, wird in dieser folgenden Sequenz jedoch der Gradient des magnetischen Gradientenfeldes Gy geändert - z.B. verringert - und der Gradient des Gradientenfeldes Gx in entgegengesetztem Sinne geändert - im Beispiel also vergrößert. Die Änderung dieser beiden Felder erfolgt dabei in bekannter Weise derart, daß der Betrag des Gradienten des aus diesen beiden Feldern resultierenden magnetischen Gradientenfeldes - zumindest in der Lesephase t2-t3 -konstant bleibt, während sich seine Richtung von Sequenz zu Sequenz ändert. Auch hierbei werden dadurch, daß für jede Sequenz das zeitliche Integral über die magnetischen Gradientenfelder einen konstanten Wert hat, die rephasierenden Anteile der Spin-Echo- und stimulierten Echosignale unterdrückt, während die dephasierenden Anteile phasenrichtig den FID-Signalen der einzelnen Hochfrequenzimpulse überlagert werden.

Wie bereits erwähnt, kann der zeitliche Abstand zwischen zwei Sequenzen 30 ms betragen, wobei am Ende einer ersten Sequenz die vor dieser Sequenz bestehende in z-Richtung verlaufende Kernmagnetisierung im Untersuchungsbereich noch nicht völlig wiederhergestellt ist. Infolgedessen ist bei der auf diese Sequenz folgenden zweiten Sequenz das Kernspin-Resonanzsignal geringer und es verringert sich von Sequenz zu Sequenz. Nach etwa 20 bis 30 Sequenzen ist jedoch ein stationärer Zustand erreicht, von dem an die Amplitude der Kernspn-Resonanzsignale nicht mehr wesentlich abnimmt. Wenn nur die Echosignale zur Rekonstruktion verwendet werden, die nach dem Erreichen des stationären Zustandes erfaßt werden, ergeben sich keine Verfälschungen. Das Signal-Rausch-Verhältnis hängt dabei von dem Flipwinkel des Hochfrequenzmpulses ab. Das günstigste Signal-Rausch-Verhältnis ergibt sich, wenn für den Flipwinkel a die Beziehung gilt

$$a = \arccos(\exp(-tr/Tl)),$$

wobei Tl die longitudinale Relaxationszeit darstellt und tr die Periodendauer einer Sequenz. Im allgemeinen ergibt sich der optimale Kontrast jedoch erst bei größeren Flipwinkeln. In der Regel wird daher mit einem größeren Flipwinkel gearbeitet als sich aus der obigen Formel ergibt, der jedoch in der Regel deutlich kleiner ist als 90°.

**Patentansprüche**

1. Verfahren für die Kernspintomographie, wobei in Anwesenheit eines homogenen stationären Magnetfeldes eine Vielzahl von Sequenzen auf einen Untersuchungsbereich (20) einwirkt, wobei jede Sequenz

- die Erzeugung eines einzigen Hochfrequenzimpulses (HF),
- das Einschalten mehrerer Gradientenfelder (Gx,Gy,Gz) mit in unterschiedlichen Richtungen verlaufenden Gradienten, von denen wenigstens eines (Gy bzw. Gx, Gy) einen nach Größe oder Richtung von Sequenz zu Sequenz veränderbaren Gradienten hat,
- die Erfassung eines Kernspinresonanzsignals während oder nach der Einwirkung dieses magnetischen Gradientenfeldes und
- im Anschluß an die Erfassung des Kernspinresonanzsignals das Einwirken wenigstens eines Gradientenfeldes (Gx,Gz) von solcher Größe und Richtung einschließt, daß das zeitliche Integral über jedes während einer Sequenz wirksame Gradientenfeld für alle Sequenzen gleich ist,

dadurch gekennzeichnet, daß zwecks Dephasierung der durch den Hochfrequenzimpuls (HF) einer jeden Sequenz angeregten Kernmagnetisierung Richtung und Größe des bzw. der nach der Erfassung des Kernspinresonanzsignals wirksamen magnetischen Gradientenfeldes(r) so gewählt sind, daß das zeitliche Integral über wenigstens ein Gradientenfeld (Gz) von Null verschieden ist.

2. Verfahren nach Anspruch 1, wobei jede Sequenz aufeinanderfolgend eine Selektionsphase, in der ein Hochfrequenzimpuls (HF) und ein erstes magnetisches Gradientenfeld (Gz) auf den Untersuchungsbereich (20) einwirken, eine Präparationsphase, in der ein zweites magnetisches Gradientenfeld (Gy) mit von Sequenz zu Sequenz veränderbarer Größe des Gradienten auf den Untersuchungsbereich (20) einwirkt, und eine Lesephase umfaßt, in der ein drittes magnetisches Gradientenfeld (Gx) auf den Untersuchungsbereich (20) einwirkt und das dabei erzeugte Kernspin-Resonanzsignal erfaßt wird, und wobei auf die Lesephase eine weitere Phase (t3-t4) folgt, während der das zweite magnetische Gradientenfeld (Gy) derart geschaltet wird, daß das zeitliche Integral über das zweite magnetische Gradientenfeld während einer Sequenz für alle Sequenzen den gleichen Wert - vorzugsweise Null - hat.

3. Verfahren nach Anspruch 1, wobei jede Sequenz eine Selektionsphase, in der ein Hochfrequenzimpuls (HF) und ein erstes magnetisches Gradientenfeld (Gx) auf den Untersuchungsbereich (20) einwirken, und eine Lesephase umfaßt, in der ein weiteres magnetisches Gradientenfeld (Gx, Gy) mit für alle Sequenzen gleicher Amplitude, jedoch von Sequenz zu Sequenz veränderbarer Richtung geschaltet wird und in der ein im Untersuchungsbereich erzeugtes Kernspin-Resonanzsignal erfaßt wird, und wobei im Anschluß an die Lesephase ein magnetisches Gradientenfeld (Gx, Gy) ein- und ausgeschaltet wird, dessen Richtung der Richtung des in der Lesephase wirksamen magnetischen Gradientenfeldes entgegengesetzt ist und dessen Größe so gewählt ist, daß das zeitliche Integral über das zweite magnetische Gradientenfeld für alle Sequenzen Null ist.

4. Verfahren nach Anspruch 2 oder 3, dadurch gekennzeichnet, daß in der auf die Lesephase folgenden Phase das erste magnetische Gradientenfeld (Gz) mit einer für alle Sequenzen gleichen Phasenlage ein- und ausgeschaltet wird.

5. Anordnung zur Durchführung des Verfahrens nach Anspruch 1 mit Mitteln zum Erzeugen eines homogenen stationären Magnetfeldes, Mitteln zum Erzeugen von Hochfrequenzimpulsen, Mitteln (3, 5, 7; 23, 25, 27) zum Erzeugen wenigstens eines magnetischen Gradientenfeldes mit von Sequenz zu Sequenz veränderbarer Größe oder Richtung des Gradienten, Mitteln zum Erfassen von Kernspin-Resonanzsignalen, Steuermitteln (15), um die Mittel (3, 5, 7; 23, 25, 27) zum Erzeugen des Gradientenfeldes bzw. der Gradientenfelder so zu steuern, daß im Anschluß an die Erfassung des Kernspinresonanzsignals ein Gradientenfeld (Gx, Gz) von solcher Größe und Richtung erzeugt wird, daß das zeitliche Integral über jedes während einer Sequenz wirksame Gradientenfeld für alle Sequenzen gleich ist, dadurch gekennzeichnet, daß die Mittel (3, 5, 7; 23, 25, 27) zum Erzeugen des Gradientenfeldes bzw. der Gradientenfelder durch die Steuermittel (15) weiters so gesteuert sind, daß zwecks Dephasierung der durch den Hochfrequenzimpuls (HF) einer jeden Sequenz angeregten Kernmagnetisierung Richtung und Größe des bzw. der nach der Erfassung des Kernspinresonanzsignals wirksamen magnetischen Gradientenfeldes(r) so gewählt sind, daß das zeitliche Integral über wenigstens ein Gradientenfeld (Gz) von Null verschieden ist.

**Claims**

1. A nuclear spin tomography method in which a plurality of sequences act on an examination zone (20) in the presence of a uniform, steady magnetic field, each sequence including

   - the generating of a single high-frequency pulse (HF),
   - the application of several gradient fields (Gx, Gy, Gz) having gradients extending in different directions, at least one of said fields (Gy of Gx, Gy) having a gradient which can be varied in respect of strength or direction from one sequence to another,
   - the detection of a spin resonance signal during or after application of said magnetic gradient field, and
   - the application, subsequent to the detection of the spin resonance signal, of at least one gradient field (Gx, Gz) of such strength and direction that the time integral overeach gradient field applied during a sequence is the same for all sequences, characterized in that for the dephasing of the nuclear magnetization excited by the high-frequency pulse (HF) of each sequence, the direction and the strength of the magnetic gradient field(s) applied after the detection of the spin resonance signal are chosen so that the time integral over at least one gradient field (Gz) differs from zero.

2. A method as claimed in Claim 1, in which each sequence comprises successively a selection phase in which a high-frequency pulse (HF) and a first magnetic gradient field (Gz) act on the examination zone (20), a preparation phase in which a second magnetic gradient field (Gy) having a gradient whose strength can be varied from sequence to sequence acts on the examination zone (20), and a read-out stage in which a third magnetic gradient field (Gx) acts on the examination zone (20) and the spin resonance signal then produced is detected, and in which the read-out phase is followed by a further phase ($t_3$-$t_4$) during which the second magnetic gradient field (Gy) is switched so that the time integral over the second magnetic gradient field during a sequence the same value, preferably zero, for all sequences.

3. A method as claimed in Claim 1, in which each sequence comprises a selection phase in which a high-frequency pulse (HF) and a first magnetic gradient field (Gx) act on the examination zone (20) and a read-out phase in which a further magnetic gradient field (Gx, Gy), having an amplitude which is the same for all sequences but a direction which is variable from sequence to sequence, is switched and spin resonance signal produced in the examination zone is detected, and in which, subsequent to the read-out phase, a magnetic gradient field (Gx, Gy) is switched on and off whose direction opposes the direction of the magnetic gradient field active in the read-out phase and whose value is chosen so that the time integral over the second magnetic gradient field is zero for all sequences.

4. A method as claimed in Claim 2 or 3, characterized in that in the phase following the read-out phase the first magnetic gradient field (Gz) is switched on and off with a phase position which is the same for all sequences.

5. A device for carrying out the method claimed in Claim 1, comprising means for generating a uniform, steady magnetic field, means for generating high-frequency pulses, means (3, 5, 7; 23, 25, 27) for generating at least one magnetic gradient field having a gradient whose value or direction is variable from sequence to sequence, means for detecting spin resonance signals, control means (15) for controlling the means (3, 5, 7; 23, 25, 27) for generating the gradient field(s) so that, subsequent to he detection of the spin resonance signal, there is generated a gradient field (Gx, Gz) having a value and direction such that the time integral over each gradient field active during a sequence is the same for all sequences, characterized in that the means (3, 5, 7; 23, 25, 27) for generating the gradient field(s) or gradient fields are controlled by the control means (15) also in such a manner that for the dephasing of the nuclear magnetization excited by the high-frequency pulse (HF) of each sequence, the direction and value of the magnetic gradient field(s) active after the detection of the spin resonance signal are chosen so that the time integral over at least one gradient field (Gz) differs from zero.

## Revendications

1. Procédé de tomographie par résonance magnétique nucléaire suivant lequel, en présence d'un champ magnétique statique homogène, un nombre de séquences agit sur un domaine d'examen (20), chaque séquence comprenant :

   la production d'une seule impulsion de haute fréquence (HF);

   l'enclenchement de plusieurs champs de gradients (Gx, Gy, Gz) dont les gradients s'étendent dans des sens différents, l'un au moins de ces champs (Gy ou Gx, Gy) présentant un gradient variable en grandeur ou en sens d'une séquence à une autre;

la détection d'un signal de résonance magnétique nucléaire pendant ou après l'action de ce champ de gradient magnétique, et

après la détection du signal de résonance magnétique nucléaire, l'action d'au moins un champ de gradient (Gx, Gz) dont la grandeur et le sens sont tels que l'intégrale dans le temps sur chaque champ de gradient actif pendant une séquence est la même pour toutes les séquences,

caractérisé en ce qu'en vue du déphasage de la magnétisation nucléaire excitée par l'impulsion de haute fréquence (HF) d'une séquence quelconque, le sens et la grandeur du ou des champs de gradients magnétiques actifs après la détection du signal de résonance magnétique nucléaire sont choisis tels que l'intégrale dans le temps sur au moins un champ de gradient (Gz) soit différente de zéro.

2. Procédé suivant la revendication 1, suivant lequel chaque séquence comprend successivement une phase de sélection dans laquelle une impulsion de haute fréquence (HF) et un premier champ de gradient magnétique (Gz) agissent sur le domaine d'examen (20), une phase de préparation dans laquelle un deuxième champ de gradient magnétique (Gy), dont le gradient varie en grandeur d'une séquence à une autre, agit sur le domaine d'examen (20), et une phase de lecture dans laquelle un troisième champ de gradient magnétique (Gx) agit sur le domaine d'examen (20) et le signal de résonance magnétique nucléaire produit ainsi est détecté et suivant lequel la phase de lecture est suivie d'une autre phase (t3 à t4) pendant laquelle le deuxième champ de gradient magnétique (Gy) est commuté de manière telle que l'intégrale dans le temps sur le deuxième champ de gradient magnétique, pendant une séquence, présente, pour toutes les séquences, la même valeur, de préférence zéro.

3. Procédé suivant la revendication 1, suivant lequel chaque séquence comprend une phase de sélection dans laquelle une impulsion de haute fréquence (HF) et un premier champ de gradient magnétique (Gx) agissent sur le domaine d'examen (20), et une phase de lecture dans laquelle un autre champ de gradient magnétique (Gx, Gy) présentant, pour toutes les séquences, la même amplitude mais un sens variable d'une séquence à une autre, est commuté, et dans laquelle un signal de résonance magnétique nucléaire produit dans le domaine d'examen est détecté, et suivant lequel, après la phase de lecture, un champ de gradient magnétique (Gx, Gy) est enclenché et déclenché, dont le sens est opposé à celui du champ de gradient magnétique actif pendant la phase de lecture et dont la grandeur est choisie telle que l'intégrale dans le temps sur le deuxième champ de gradient magnétique est pratiquement égale à zéro pour toutes les séquences.

4. Procédé suivant la revendication 2 ou 3, caractérisé en ce que, pendant la phase succédant à la phase de lecture, le premier champ de gradient magnétique (Gz) est enclenché et déclenché avec une position de phase qui est la même pour toutes les séquences.

5. Dispositif pour l'exécution du procédé suivant la revendication 1, comportant des moyens pour produire un champ magnétique statique homogène, des moyens pour produire des impulsions de haute fréquence, des moyens (3, 5, 7; 23, 25, 27) pour produire au moins un champ de gradient magnétique dont le gradient est variable en grandeur ou en sens d'une séquence à une autre, des moyens pour détecter des signaux de résonance magnétique nucléaire, des moyens de commande (15) pour commander les moyens (3, 5, 7; 23, 25, 27) de production du ou des champs de gradients d'une manière telle qu'après la détection du signal de résonance magnétique nucléaire, un champ de gradient (Gx, Gz) soit produit, dont la grandeur et le sens sont tels que l'intégrale dans le temps, sur chaque champ de gradient actif pendant une séquence, soit la même pour toutes les séquences,

caractérisé en ce que les moyens (3, 5, 7; 23, 25, 27) de la production du ou des champs de gradients sont, en outre, commandés par les moyens de commande (15) de manière telle qu'en vue du déphasage de la magnétisation nucléaire excitée par l'impulsion de haute fréquence (HF) d'une quelconque séquence, le sens et la grandeur du ou des champs de gradients magnétiques (r) actifs après la détection du signal de résonance magnétique actif après la détection du signal de résonance magnétique nucléaire sont choisis tels que l'intégrale dans le temps sur au moins un champ de gradient (Gz) soit différente de zéro.

FIG.1

# FIG. 2

EP 0 248 469 B1

FIG. 3

FIG. 4

12

FIG. 5